# EUROPEAN PATENT APPLICATION

(11) **EP 4 492 434 A1**
(43) Date of publication of application: **15.01.2025**
(21) Application number: 24187990.7
(22) Date of filing: 11.07.2024
(51) Int. Cl.: H01L 21/20

(54) **METHOD FOR GRAPHENE LAYER GROWTH AND SIMULTANEOUS MOLYBDENUM SILICIDE FORMATION ON A SEMICONDUCTOR DEVICE**

(30) Priority: 11.07.2023 US 202318350465
(71) Applicant: STMicroelectronics International N.V., 1228 Plan-les-Ouates, Geneva (CH); Consiglio Nazionale Delle Ricerche, 00185 Roma (IT)
(72) Inventor: D'ARRIGO, Giuseppe, 95037 SAN GIOVANNI LA PUNTA (CT) (IT); SCIUTO, Antonella, 95037 SAN GIOVANNI LA PUNTA (CT) (IT); PRIVITERA, Vittorio, 95100 ACICASTELLO (CT) (IT); COFFA, Salvatore, 20147 MILANO (IT); MELLO, Domenico Pierpaolo, 95121 CATANIA (IT)
(74) Representative: Studio Torta S.p.A.

(57) **Abstract**

A method for forming a graphene layer on a semiconductor substrate, a semiconductor diode utilizing the method for graphene layer formation, and an optoelectronic semiconductor device also utilizing the method for graphene layer formation are provided. An example method for disposing a graphene layer (412) on a semiconductor substrate (202) may include depositing a metal catalyst layer on a top surface of the semiconductor substrate (202) and patterning the metal catalyst layer, such that one or more portions (308) of the top surface of the semiconductor substrate are covered by one or more metal catalyst layer structures. The method may further include facilitating a graphene growth process on an exposed surface of the one or more metal catalyst layer structures (308), wherein the graphene growth process forms the graphene layer (412) on the exposed surfaces of the one or more metal catalyst layer structures.

## Description

### TECHNOLOGICAL FIELD

The present invention refers to a graphene growth process on a semiconductor substrate, and more particularly, to simultaneous graphene layer growth and molybdenum silicide formation on a semiconductor device.

### BACKGROUND

Graphene has several unique properties that make it attractive for use in semiconductor technology. For example, graphene has high electron mobility, high thermal conductivity, is flexible and transparent, and is resistive to degradation. However, the utility of graphene use in electronics is limited by several constraints, primarily, the complexity associated with growing graphene directly onto a semiconductor device.

Aim of the present invention is to provide a solution to overcome the above limitations.

### BRIEF SUMMARY

According to the present invention, a method for forming a graphene layer on a semiconductor substrate is provided, according to the attached claims.

### BRIEF DESCRIPTION OF THE DRAWINGS

Reference will now be made to the accompanying drawings. The components illustrated in the figures may or may not be present in certain embodiments described herein. Some embodiments may include fewer (or more) components than those shown in the figures in accordance with an example embodiment of the present disclosure.
FIG. 1 depicts a flow chart for an example process for forming a graphene layer on a semiconductor substrate in accordance with one or more embodiments of the present disclosure.
FIG. 2 - FIG. 4 illustrate a cross-section view of an example process for forming a graphene layer on a semiconductor substrate in accordance with one or more embodiments of the present disclosure.
FIG. 5 illustrates an example process for graphene growth using a chemical vapor deposition process in accordance with one or more embodiments of the present disclosure.
FIG. 6 illustrates an additional embodiment of a process for forming a graphene layer simultaneous with catalytic metal silicide formation in accordance with one or more embodiments of the present disclosure.
FIG. 7 illustrates an example semiconductor diode utilizing a graphene layer formed in accordance with one or more embodiments of the present disclosure.
FIG. 8 illustrates an example optoelectronic semiconductor device utilizing a graphene layer formed in accordance with one or more embodiments of the present disclosure.
FIG. 9 illustrates an example semiconductor device depicting an uneven top surface covered by a graphene layer and metal silicide layer in accordance with an example embodiment of the present disclosure.
FIG. 10 illustrates an example semiconductor device depicting an uneven top surface covered by a graphene layer in accordance with an example embodiment of the present disclosure.

### DETAILED DESCRIPTION

Example embodiments will be described more fully hereinafter with reference to the accompanying drawings, in which some, but not all embodiments of the inventions of the disclosure are shown. Like numbers refer to like elements throughout.

As used herein, terms such as "front," "rear," "behind," "top," "vertical," "horizontal," "above," "below," "over", "under", etc. are used for explanatory purposes in the examples provided below to describe the relative positions of certain components or portions of components relative to a local reference frame of an electrical device using an arbitrary global reference frame.

Various example embodiments address technical problems associated with forming a graphene layer on a semiconductor device and simultaneous generation of a metal silicide contact. As understood by those of skill in the field to which the present disclosure pertains, there are numerous example scenarios in which a user may desire the formation of a graphene layer on a semiconductor device. And further example scenarios in which it may be beneficial to simultaneously form a metal silicide contact during the formation of the graphene layer.

For example, graphene has several unique properties that make it attractive for use in semiconductor technology. In general, graphene is a single layer of carbon atoms formed into a tightly bound hexagonal lattice. Graphene has high electron and hole mobility allowing these molecules increased freedom of movement leading to better device performance. Graphene has excellent thermal properties of use in semiconductor devices, including high thermal conductivity along the plane and lower thermal conductivity orthogonally to the plane. As such, a graphene layer in a semiconductor device may act as a thermal barrier. Graphene is flexible and transparent, meaning graphene may be used for applications requiring a transparent optical collector, such as an optoelectronic semiconductor device. The transparent nature of graphene may also enable applications requiring the emission of light output, such as a laser diode. Graphene is also highly resistive to degradation, enabling use of graphene as a protective layer on a semiconductor device.

However, the utility of graphene electronics is limited by several constraints. The main limitation of increased use of graphene in semiconductor devices is the complexity associated with growing graphene directly on a semiconductor substrate of a semiconductor device. Previous examples have sought to grow graphene layers separately and mechanically transfer the graphene layers to the semiconductor substrate of a semiconductor device. Growing graphene separately enables the use of copper as a catalyst layer. Copper is well suited as a basis for graphene growth, however, copper is characterized by high diffusivity in semiconductor material, further induced by the presence of carbon. Thus, it is impossible to put copper in direct contact with the semiconductor substrate due to its high diffusivity inducing not only contamination but also degradation of crystalline structure of the semiconductor substrate. Comingling copper and semiconductor material must be avoided in microelectronics fabrication. Copper contamination changes the mobility properties of the underlying semiconductor materials, negatively affecting the operation of the semiconductor device. By growing graphene separately, copper contamination of the semiconductor device may be avoided.

In addition, growing graphene separately protects the components of the semiconductor device from damage due to high annealing temperatures. High annealing temperatures may be used to enable the graphene growth process, particularly on copper. High annealing temperatures may be damaging to the underlying semiconductor components of the semiconductor device. Thus, growing graphene separately and mechanically transferring the graphene may prevent exposure of the semiconductor components to the high annealing temperatures.

Unfortunately, the mechanical transfer of graphene layers can be complex, inaccurate, and result in a damaged graphene layer. For example, the transfer of graphene layers may result in wrinkles, cracks, or tears in the graphene layer. The damaged graphene layer may affect the beneficial properties of the graphene. In addition, sometimes, the graphene layer may need to be aligned with the underlying components of the semiconductor device. Aligning graphene layers by mechanical transfer may be difficult and the resulting alignment may be inaccurate. Further, once the graphene layer is placed, the polymethyl methacrylate (PMMA) layer used to aid the transfer of the graphene layer may be dissolved. Dissolving the PMMA layer may damage the underlying semiconductor components and may laterally shift the graphene layer, resulting in misalignment of the graphene layer. Moreover, it is impossible to transfer a patterned graphene layer without errors, in particularly when aligning features at a micrometer and/or nanometer scale.

In addition, graphene layers grown separately on copper must be treated to avoid any copper presence after the mechanical transfer. The presence of copper after transfer contaminate the underlying semiconductor substrate and semiconductor device components.

Other examples have attempted to grow a graphene layer directly on a Silicon Carbide substrate or on a protective dielectric layer. Epitaxial growth of graphene on Silicon Carbide may require high temperatures, for example, above 1600 degrees Celsius. Such temperatures may be damaging to the semiconductor components on a semiconductor device and may require the use of a protective dielectric layer. Use of a protective dielectric layer prevents direct electrical connection of the graphene layer with the underlying semiconductor substrate.
hereinafter, a process is described for growing a graphene layer on a semiconductor substrate, such as Silicon or Silicon Carbide, using a catalyst metal layer and epitaxial growth by chemical vapor deposition.

As described herein, the process for growing graphene includes first depositing a metal catalyst layer on a semiconductor substrate. The metal catalyst layer may be deposited using a sputtering process. The metal catalyst may comprise, for example, molybdenum or nickel.

The process for growing graphene further includes patterning the metal catalyst layer. Patterning the metal catalyst layer may involve well-known and reliable lithography processes. Lithographic processes may include photolithography processes or any kind of patterning methodologies for creating micrometric and nanometric structures. In this way, the metal catalyst layer may be defined by etching or by lift-off procedure to form one or more metal catalyst layer structures aligned with the underlying semiconductor components. Graphene growth may be limited such that graphene is only formed on the metal catalyst layer structures, thus graphene growth and alignment may occur in a single step.

The graphene growth process continues by facilitating a graphene growth process on an exposed surface of the metal catalyst layer structures. The graphene growth process may be facilitated by performing an epitaxial growth process, such as chemical vapor deposition (CVD). The CVD process utilizes a molecular precursor introduced in gaseous form to form a layer of material on the support layer, for example, the metal catalyst layer. The precursor utilized to form graphene on the metal catalyst may be, for example, methane gas, acting as a carbon precursor. Utilizing a metal catalyst layer such as molybdenum, the CVD process may be executed at temperatures at or around 900 degrees Celsius, compared to a temperature of 1600 degrees Celsius when using a thermal growth process. In addition to the formation of graphene during CVD, the metal catalyst layer may be converted into a metal silicide by reacting with the silicon of the underlying substrate layer. For example, the molybdenum may be converted into molybdenum silicide.

The techniques described herein enable the metal catalyst layers to be structured such that the entire metal catalyst layer structure is transitioned to a silicide. This may be accomplished by reducing the thickness of the metal catalyst layer and/or increasing the time of the CVD process. The transition of the entire metal catalyst layer to a metal silicide may enable the formation of certain electrical contacts, such as Schottky contacts between the graphene layer and a lightly-doped silicon or silicon carbide substrate, or ohmic contacts between the graphene layer and a heavily doped region of the silicon or silicon carbide substrate.

By utilizing a process involving the growth of a graphene layer on a metal catalyst layer using chemical vapor deposition, the complex process of the mechanical transfer of separately grown graphene layers resulting in an inaccurate and inefficient graphene layer becomes obsolete. In addition, the high temperatures required for thermal growth of graphene, detrimental to the fabrication of semiconductor devices, may be avoided.

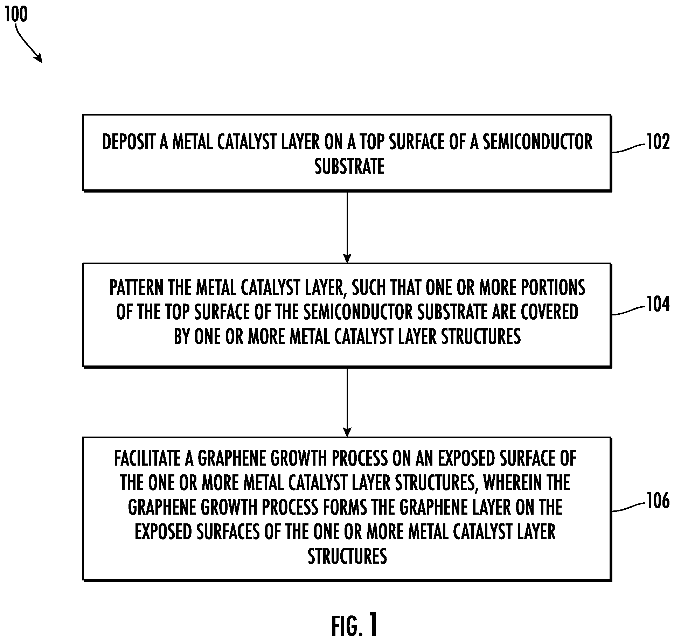

Referring now to FIG. 1, an example process 100 for disposing a graphene layer on a semiconductor substrate is provided. At block 102, a metal catalyst layer is deposited on a top surface of the semiconductor substrate. A semiconductor substrate may be any semiconductor material upon which or within which the elements of a semiconductor device are fabricated or attached. A semiconductor substrate may comprise Silicon, Germanium, Gallium Arsenide, Gallium Nitride, Silicon Carbide (SiC), or other similar semiconductor material. Elements of the semiconductor device may be formed by doping, for example, via implantation, deposition of materials, masking, etching, epitaxial growth, sputtering, annealing, and other lithographic techniques.

A semiconductor substrate may be prepared from a pure semiconductor material and grown into a crystal ingot. The semiconductor ingot may then be sliced into wafers to facilitate the fabrication of one or more semiconductor devices. The sliced wafers may be etched and polished creating a surface (e.g., top surface) prepared for further semiconductor fabrication operations.

One such semiconductor operation is the deposition of metals, such as the metal catalyst layer. Metal deposition may be accomplished through any process in which a metallic starter material is deposited on the surface of the semiconductor substrate. Common techniques for deposition of a metal on a semiconductor substrate include physical vapor deposition (PVD) and chemical vapor deposition (CVD). PVD may be commonly accomplished through sputtering or evaporation. CVD may be commonly accomplished by exposing the surface of the semiconductor substrate to one or more precursors configured to react and/or decompose on the surface of the substrate to produce the desired deposit.

The metal catalyst layer may comprise any metal material that is deposited on the surface of the semiconductor substrate without contaminating the semiconductor substrate. In addition, the metal catalyst layer comprises a metal material configured to form a basis for CVD growth of graphene on the surface of the metal material and the formation of silicides with the semiconductor substrate.

At block 104, the metal catalyst layer is patterned, such that one or more portions of the top surface of the semiconductor substrate are covered by one or more metal catalyst layer structures. A metal catalyst layer may be patterned using any lithography patterning technique. Metal pattering techniques may include lift-off techniques, evaporation using shadow masks, dry or wet etching techniques, or any other metal patterning technique. Wet and/or dry etching techniques may include depositing a protective layer on the surface of the metal catalyst layer, such as photoresist, and patterning the protective layer to expose surfaces of the metal catalyst layer to be etched. Wet etching techniques may include the use of acids or chemical solutions. Dry etching techniques may include chemical dry etching, such as, plasma dry etching. Etching portions of the metal catalyst layer unprotected by a protective layer results in metal catalyst layer structures, comprising the remaining portions of the metal catalyst layer, deposited on the top surface of the semiconductor substrate.

Metal catalyst layer structures are any portions of the metal catalyst layer remaining on the surface of the semiconductor substrate and configured to facilitate one or more functions with regard to a semiconductor device. For example, on a transistor semiconductor device, metal catalyst layer structures may include, the drain, source, gate, or other electrical contacts of the transistor. In a Schottky diode, the metal catalyst layer structures may comprise the metal portion connected to the anode of the Schottky diode. In some embodiments, the metal catalyst layer structures may be the electrical contact between a contact pad and the underlying structures in the semiconductor substrate, for example, an ohmic contact.

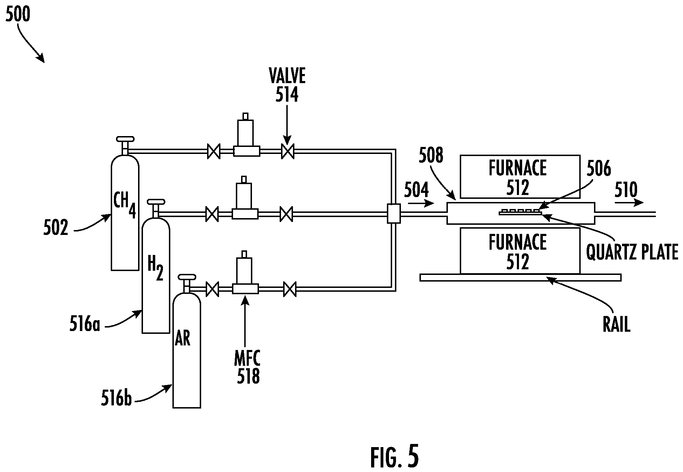

At block 106, the graphene growth process is facilitated on an exposed surface of the one or more metal catalyst layer structures, wherein the graphene growth process forms the graphene layer on the exposed surfaces of the one or more metal catalyst layer structures. Graphene growth may be facilitated on the exposed surfaces of the metal catalyst layer structures via CVD. The CVD process is described further in relation to FIG. 5. By utilizing the exposed surfaces of the patterned metal catalyst layer structures to facilitate the growth of graphene, the graphene is aligned with the metal catalyst layer structures, and thus, the underlying components of the semiconductor device, without additional alignment steps.

In addition, during the graphene growth process, portions of the metal catalyst layer are converted into a metal silicide between the metal catalyst layer and the silicon substrate. Thus, metal silicide formation occurs in coordination with the growth of graphene.

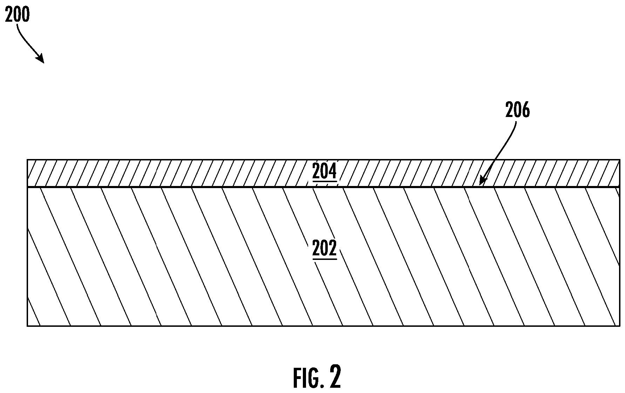

Referring now to FIG. 2 - FIG. 4, an example process for disposing a graphene layer on a semiconductor substrate is provided. Referring to FIG. 2, an example semiconductor device 200 is provided. As depicted in FIG. 2, the example semiconductor device 200 includes a semiconductor substrate 202 having a top surface 206 and a metal catalyst layer 204 disposed adjacent to the top surface 206 of the metal catalyst layer 204.

As depicted in FIG. 2, the semiconductor device 200 includes a semiconductor substrate 202. As described herein, the semiconductor substrate 202 may be any semiconductor material upon which or within which the elements of a semiconductor device are fabricated or attached. As depicted in FIG. 2, the semiconductor substrate 202 comprises Silicon Carbide. A SiC substrate may produce a number of benefits, particularly in high-power applications. For example, SiC-based semiconductor components may dissipate heat more efficiently, be more tolerant to higher frequencies, have a low reverse leakage current and power dissipation, be more stable across a wide temperature range, have lower electromagnetic radiations, and provide other related advantages.

As further depicted in FIG. 2, the metal catalyst layer 204 is deposited on the top surface 206 of the semiconductor substrate 202. The metal catalyst layer 204 may be deposited utilizing any metallization technique enabling the uniform deposition of the catalyst metal on the top surface 206 of the semiconductor substrate 202, for example, sputtering techniques. Sputtering is a form of PVD which may be used to deposit thin metal layers on semiconductor substrates 202. In sputtering, a source metal material may be placed in a vacuum chamber with the semiconductor substrate 202. The source may be bombarded with a sputtering gas, causing particles of the source metal material to escape and deposit on the surface of the semiconductor substrate 202. Sputtering may deposit a layer of material (e.g., a metal catalyst layer 204) on the surface of the semiconductor substrate 202.

The metal catalyst layer 204 may be deposited at a uniform thickness.

For example, the thickness of the metal catalyst layer 204 may be between 35 nanometers and 65 nanometers; preferably between 40 nanometers and 60 nanometers; and more preferably between 45 nanometers and 55 nanometers.

The metal catalyst layer 204 may comprise molybdenum. Molybdenum provides a base surface for uniform graphene growth. Molybdenum is a particularly effective base for graphene growth for a number of reasons. For one, molybdenum enables uniform graphene growth on a large area. Molybdenum also has a high melting temperature, around 2600 degrees Celsius, enabling the metal catalyst layer 204 to withstand high temperatures. A metal catalyst layer 204 comprising molybdenum may further be etched using simple solutions, such as hydrogen peroxide (H₂0₂) and nitric acid (HNO₃). In addition, use of molybdenum as a metal catalyst layer promotes the formation of metal silicides between the semiconductor substrate 202 (SiC) and the metal catalyst layer 204 (molybdenum) during graphene growth. The metal silicide formation results in a mechanically and chemically stable layer as well as an optical electrical contact between the graphene and the semiconductor substrate 202. In some embodiments, the metal catalyst layer 204 comprises Nickel.

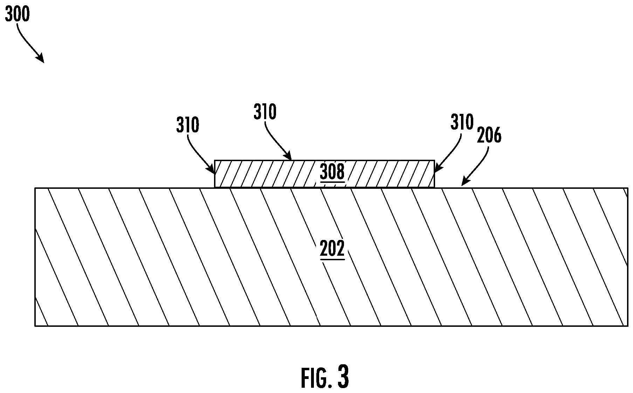

Referring now to FIG. 3, the semiconductor device 300 is further depicted wherein the metal catalyst layer 204 has been etched to form one or more metal catalyst layer structures 308 on the top surface 206 of the semiconductor substrate 202, thereby forming semiconductor device 300. In addition, one or more exposed surfaces 310 of the metal catalyst layer structure 308 are exposed to the outer environment.

As depicted in FIG. 3, the semiconductor device 300 includes one or more metal catalyst layer structures 308. As described herein, the patterning of the metal catalyst layer 204 to form metal catalyst layer structures 308 may be accomplished using any photolithography patterning technique, for example, a metal etching photolithography process utilizing wet etching techniques. In some embodiments, a patterned protective layer or mask may be applied to the surface of the metal catalyst layer 204. The patterned protective mask may protect regions of the metal catalyst layer 204 from etchants, while defining exposed regions of the metal to be etched or removed. In the depicted example of FIG. 3, in which the metal catalyst layer 204 comprises molybdenum, a variety of etching techniques may be utilized to remove the portions of the metal catalyst layer 204 unprotected by the patterned protective mask. For example, lift-off resist patterning, sputter and resist stripping, evaporation and resist stripping, wet etching techniques using etchants such as hydrogen peroxide and nitric acid, dry etching techniques, shadow mask and evaporation techniques, and so on. Once the etching is complete, the patterned protective mask may be removed, leaving the metal catalyst layer structures 308.

As described herein, the metal catalyst layer structures 308 may comprise any conductive structure performing a function of the semiconductor device 300. For example, in some embodiments, a metal catalyst layer structure 308 may perform functions of the active layer of a transistor on a semiconductor device 300, for example, on a graphene field-effect transistor. By placing a metal catalyst layer structure 308 and later forming a graphene layer between the source and drain of a transistor, the transistor may exhibit exceptional thermal and conductivity properties, including low resistance losses and better heat dissipation than silicon.

Then, a graphene layer is formed, thereby obtaining a semiconductor device 400.

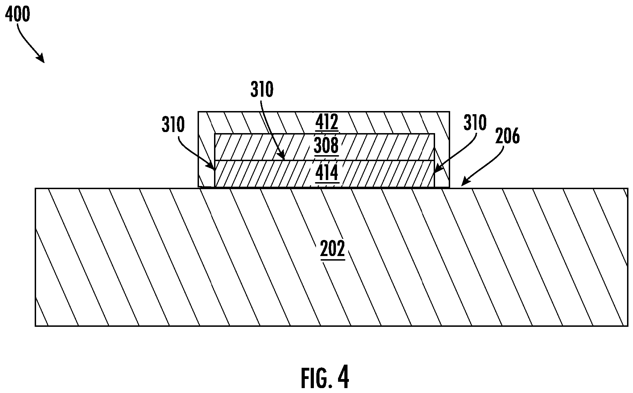

Referring now to FIG. 4, the semiconductor device 400 includes a graphene layer 412 formed on the exposed surfaces 310 of the metal catalyst layer structure 308. In addition, a metal silicide layer 414 has formed between the top surface 206 of the semiconductor substrate 202 and the metal catalyst layer structure 308.

The graphene layer 412 is formed on the exposed surfaces 310 of the metal catalyst layer structure 308 using a CVD process. FIG. 5 depicts an example CVD process 500. Referring to FIG. 5, the example CVD process 500 is configured to expose a semiconductor device 506 to one or more precursor gases 502a - 502c under elevated temperatures provided by one or more furnaces.

As depicted in FIG. 5, the semiconductor device 506 (e.g., semiconductor device 300) may be placed in a reaction chamber 508. The reaction chamber 508 includes a gas inlet 504 configured to carry a precursor gas 502 and one or more carrier gases 516a - 516b into the reaction chamber 508. The reaction chamber 508 further comprises a gas outlet 510 configured to produce a gas flow through the reaction chamber 508 enabling continued reaction of the precursor gas 502 with the exposed surfaces of the semiconductor device 506 and removing volatile byproducts of the CVD process 500.

In addition, a vacuum is created in the reaction chamber 508 and the temperature elevated by one or more furnaces 512. The vacuum created by the reaction chamber 508 and the elevated temperatures created by the furnaces 512 create an environment in which a graphene layer (e.g., graphene layer 412 as depicted in FIG. 4) may grow on the exposed surfaces 310 of the metal catalyst layer structures 308 on the semiconductor device 506 when reacting with the precursor gas 502.

The pressure in the reaction chamber 508 may be controlled, for example, low pressure chemical vapor deposition (LPCVD) techniques may be used. Reduced pressure in the reaction chamber 508 may decrease undesirable gas reactions and may increase the uniformity of the deposition on the semiconductor device 506. The pressure of the reaction chamber 508 may be held between 1 and 15 millibars; preferably between 1.5 and 12.5 millibars; more preferably between 2 and 10 millibars.

As further depicted in FIG. 5, the example CVD process 500 includes the release of a precursor gas 502 into the reaction chamber 508. The precursor gas 502 may include any gas or combination of gases comprising a carbon precursor which when exposed to the surface of the metal catalyst layer 204 of the semiconductor device 506 forms a graphene layer (e.g., graphene layer 412). The carbon precursor gas 502 may include methane gas. The CVD process 500 may also include the release of carrier gases 516a - 516b into the reaction chamber 508. Carrier gases 516a - 516b may enhance the surface reaction of graphene on the surface of the metal catalyst layer structures 308.Carrier gases 516a - 516b may comprise hydrogen gas, argon gas, acetylene, other carbon gases, or a combination thereof.

As depicted in FIG. 5, the release of the precursor gas 502 and the one or more carrier gases 516a - 516b is controlled by one or more mass flow controllers (MFC) 518. Further control of the precursor gas 502 concentration and the carrier gas 516a - 516b may be controlled by one or more valves 514, controlling the flow of gas from the precursor gas 502 and carrier gases 516a - 516b sources into the reaction chamber 508 through the gas inlet 504.

The temperature of the reaction chamber 508 may be heated to a range between 800 and 1000 degrees Celsius; preferably between 850 and 950 degrees Celsius; more preferably between 875 and 925 degrees Celsius. The semiconductor device 506 may be exposed to the precursor gas 502 for a duration between 550 and 750 seconds; preferably between 575 and 725 seconds; more preferably between 600 and 700 seconds.

Returning to FIG. 4, the metal comprising the metal catalyst layer structures 308 is selected such that the metal catalyst layer structures 308 form metal silicides with the semiconductor substrate 202 during the CVD process enabling the growth of graphene. Metal silicides may be formed at the contact surface between the semiconductor substrate 202 and the metal catalyst layer structure 308 in the presence of heat. For example, the atoms of the metal catalyst layer structure 308 may diffuse across boundaries of the metal catalyst layer structure 308 and fuse with the particles of the semiconductor substrate 202. Metal silicides exhibit reduced contact resistance enabling improved performance of the electrical contacts within a semiconductor device 400. Further, metal silicides are able to withstand high temperatures, enabling use on high temperature electrical devices.

In particular, when the metal catalyst layer structures 308 comprise molybdenum, the metal catalyst layer structures 308 may combine with the Silicon or Silicon Carbide semiconductor substrate 202 to form Molybdenum Disilicide (MoxSi_{y}) or another molybdenum silicide with a different stoichiometry. In the alternative, when the metal catalyst layer structures 308 comprise nickel, the metal catalyst layer structures 308 may combine with the Silicon or Silicon Carbide semiconductor substrate 202 to form Nickel Silicide (NiₓSiy) or another nickel silicide with a different stoichiometry.

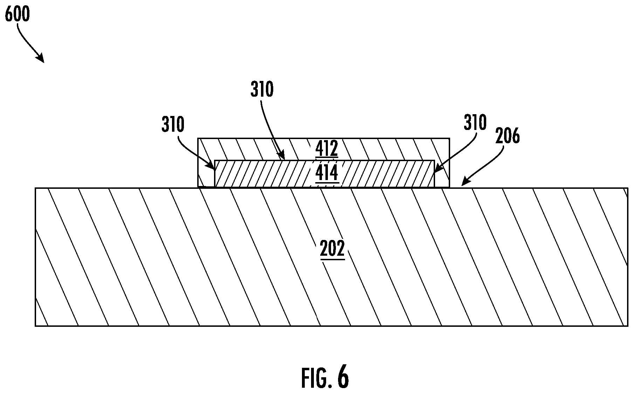

The metal catalyst layer structures 308 may be completely converted into a metal silicide, as shown in FIG. 6, based on the thickness of the metal catalyst layer structures 308 and the duration and temperature of the graphene growth process.

FIG. 6 shows a semiconductor device including the metal silicide layer 414 disposed on the top surface 206 of the semiconductor substrate 202 and the graphene layer disposed on all the exposed surfaces 310 of the metal silicide layer 414.

As depicted in FIG. 6, the metal silicide layer 414 is in direct contact with both the graphene layer 412 and the semiconductor substrate 202,. , since the entire metal catalyst layer structure 308 has been converted into a metal silicide.

In particular, depositing the metal catalyst layer 204 at the thickness indicated above (between 35 nanometers and 65 nanometers; preferably between 40 nanometers and 60 nanometers; and more preferably between 45 nanometers and 55 nanometers) may enable the entire resulting metal catalyst layer structure 308 to be converted to a silicide, forming the metal silicide layer 414.

The temperature and duration of the graphene growth process, as described in FIG. 5, in part affects the conversion of the metal catalyst layer structure 308 to a silicide. For example, the temperature of the reaction chamber (e.g., reaction chamber 508 of FIG. 5) in the graphene growth process indicated above between 875 and 925 degrees Celsius, the exposition of the semiconductor device to the precursor and carrier gases indicated above (for between 600 and 700 seconds) may help in converting the entire metal catalyst structure 308 into a metal silicide layer.

Converting the entire metal catalyst layer structure 308 into a metal silicide puts the graphene layer in direct contact with the metal silicide layer 414 which is in turn contacting the semiconductor substrate 202, as shown in FIG: 6.

The metal silicide layer 414 creating an electrical contact (e.g., contact point) between a graphene layer 412 and the semiconductor substrate may provide a number of benefits. As described herein, a metal silicide layer 414 contact exhibits reduced contact resistance when compared to a metal-semiconductor contact. In addition, metal silicide layer 414 contacts enable continued performance at high temperatures.

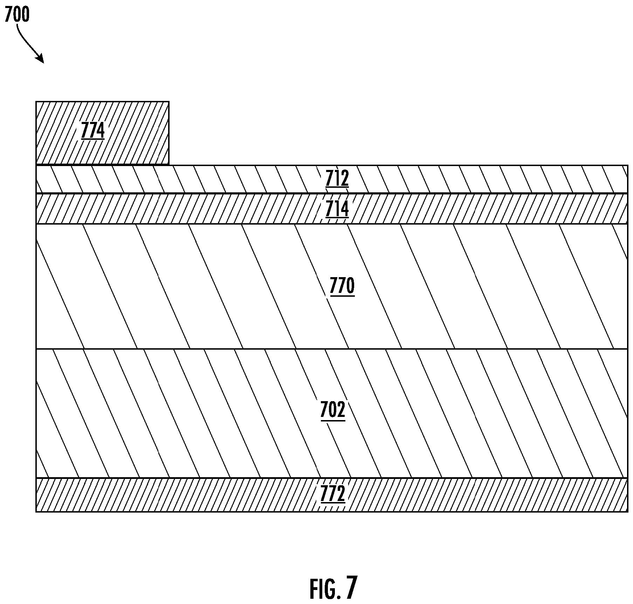

In addition, as described in relation to FIG. 7, metal silicide layer 414 contact may act as a passive layer in a semiconductor device, providing a Schottky contact between the graphene and the semiconductor substrate 202. Further, metal silicide layer 414 may provide an ohmic contact between the metal layer (here, graphene layer 412) of a semiconductor device and the semiconductor substrate. An ohmic contact is based on the work functions of the metal and the semiconductor. For example, for a metal and an n-type semiconductor, an ohmic contact is formed when the metal work function is smaller than or equal to the semiconductor work function. Similarly, for a metal and a p-type semiconductor, an ohmic contact is formed when the metal work function is greater than or equal to the semiconductor work function. Thus, in high doped semiconductor it is easier to form ohmic contact than in low doped semiconductor due to the Fermi level lying near to the conduction and the valence band for n- and p-type semiconductors respectively. A metal silicide contact forms a more stable contact (both ohmic or Schottky contact) compared to a metal contact.

For example, an ohmic contact may be formed between the graphene layer 412 and the semiconductor substrate 202 in an instance in which the region of the semiconductor substrate 202 contacting the metal catalyst layer structures 308 is a p-type semiconductor with a high doping concentration.

Referring now to FIG. 7, an example Schottky diode semiconductor device 700 is provided. As depicted in FIG. 7, the example Schottky diode semiconductor device 700 includes a semiconductor drift layer 770 on top of a semiconductor substrate 702.

As further depicted, a metal silicide Schottky contact 714 is disposed on top of the semiconductor drift layer 770 and forms an electrical contact between the semiconductor drift layer 770 and a graphene layer 712 disposed on top of the metal silicide Schottky contact 714.

Metal silicide Schottky contact 714 has been formed as discussed above with reference to FIG.s 2-6.

On the top surface of the graphene layer 712, an anode terminal 774 is disposed.

In addition, an ohmic contact is formed at a cathode terminal 772 (e.g., backside ohmic contact) on the bottom surface of the semiconductor substrate 702.

The semiconductor substrate 702 (e.g., wafer) may be any semiconductor material serving as the base layer of a semiconductor component (e.g., Schottky diode semiconductor device 700). The semiconductor substrate 702 may comprise Silicon, Silicon Carbide (SiC), or other similar semiconductor material.

The semiconductor substrate 702 may be doped by a first dopant type to create a semiconductor having a particular conductivity type, for example, an n-type dopant. A dopant may be any impurity deliberately added to a semiconductor to modify the electrical conductivity of the semiconductor. Adding a dopant to the semiconductor substrate 702 with extra valence electrons creates a semiconductor with an n-type doping or an n-doped semiconductor. Dopants having extra valence electrons may include Phosphorus, Arsenic, Antimony, etc. Alternatively, adding a dopant to the semiconductor substrate 702 with a shortage of valence electrons creates a semiconductor with a p-type doping or a p-doped semiconductor. Dopants having a shortage of valence electrons may include Boron, Aluminum, Gallium, etc. For example, the semiconductor substrate 702 of the example Schottky diode semiconductor device 700 is an n-typed semiconductor substrate 702.

The semiconductor substrate 702 may comprise a doping concentration. A doping concentration may refer to the number of impurities introduced into the semiconductor substrate 702 structure relative to the number of intrinsic semiconductor atoms. A high doping concentration meaning a larger number of impurities are introduced into the semiconductor substrate 702 relative to the number of intrinsic semiconductor atoms. The doping concentration of the semiconductor substrate 702 may be higher than the doping concentration of the semiconductor drift layer 770. Here, the semiconductor substrate 702 comprises a high doping concentration of an n-type dopant compared to the semiconductor drift layer 770.

Semiconductor drift layer 770 may be any semiconductor material configured to enable the flow of current from the graphene layer 712 to the cathode terminal 772 as a result of the drift of majority carriers. The semiconductor drift layer 770 enables the flow of current from the graphene layer 712 to the cathode terminal 772 when the barrier voltage of the Schottky diode semiconductor device 700 is exceeded. Further, the semiconductor drift layer 770 blocks or limits the flow of current in the reverse direction, e.g., from the cathode terminal 772 to the anode terminal. In the considered example, the semiconductor drift layer 770 is of the same dopant type as the semiconductor substrate 702, e.g., an n-type semiconductor and has a lower doping concentration than the semiconductor substrate 702.

The graphene layer 712 is the layer through which current enters the Schottky diode semiconductor device 700, or equivalently, electrons leave the Schottky diode semiconductor device 700. The graphene layer 712 here is in contact with the top surface of the semiconductor drift layer 770 through the metal silicide Schottky contact 714. A junction between metal silicide Schottky contact 714 and drift layer 707 forms a semiconductor diode.

In general, the metal silicide Schottky contact 714 combines low voltage-drop characteristics with negligible recovery. Thus, a metal silicide Schottky contact 714 may be less likely to overheat at high voltages, may allow the transfer of current with higher efficiency, and may perform well at high frequencies.

The cathode terminal 772 may be any conductive material (e.g., back-side metal) through which current exits the Schottky diode semiconductor device 700, or equivalently, electrons enter the Schottky diode semiconductor device 700. The cathode terminal 772 may comprise a metal, or combination of metals, such as molybdenum, platinum, chromium, tungsten, nickel, or other similar conductive material. For example, the cathode terminal 772 may be disposed below the semiconductor substrate 702, adjacent to the bottom surface of the semiconductor substrate 702.

The anode terminal 774 may be any conductive surface configured to provide an electrical connection to the graphene layer 712 of the Schottky diode semiconductor device 700. Anode terminal 774 may comprise any conductive material, including gold, copper, aluminum, or other similar material.

Anode terminal 774 provides a point of contact to an external source through which current enters the Schottky diode semiconductor device 700, or equivalently, electrons leave the Schottky diode semiconductor device 700.

Due to the efficient carrier collection and in plane transport of the graphene layer 712, the physical size of the anode terminal 774 may be reduced. For example, a thinner metal layer as compared to non-graphene layers may be adopted.

Further, utilizing the techniques described herein, the graphene layer 712 may be aligned with the underlying features of the Schottky diode semiconductor device 700 during the graphene growth process.

In addition, utilizing graphene layer 712 as a passive layer in a Schottky diode semiconductor device 700 may result in a higher performing Schottky diode semiconductor device 700, especially in high power applications.

Further, the graphene layer 712 provides a protective layer against oxidation, ion diffusion, or other damaging conditions caused by the surrounding environment. Thus, an electronic device utilizing graphene layer 712 may be used in environments generally harsh to electronic devices.

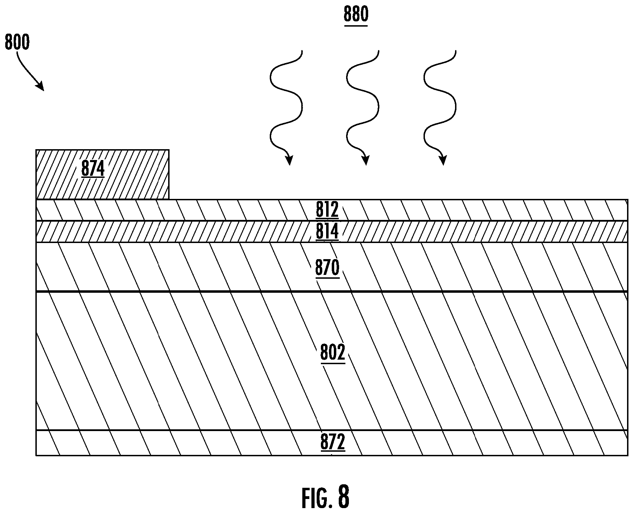

Referring now to FIG. 8, an example optoelectronic semiconductor device 800 is provided. As depicted in FIG. 8, the example optoelectronic semiconductor device 800 includes a semiconductor drift layer 870 on top of a semiconductor substrate 802.

As further depicted, a metal silicide contact 814 is disposed on top of the semiconductor drift layer 870 and forms an electrical contact between the semiconductor drift layer 870 and a graphene layer 812 disposed on top of the metal silicide contact 814.

Metal silicide contact 814 may be a Schottky contact.

Metal silicide contact 814 may be formed as discussed above for metal silicide layer 414.

On the top surface of the graphene layer 812, an anode terminal 874 is disposed.

In addition, an ohmic contact (e.g., backside ohmic contact) is formed at a cathode terminal 872 on the bottom surface of the semiconductor substrate 802.

As further depicted in FIG. 8, the graphene layer 812 may be exposed to photons 880 from an external environment.

As for semiconductor substrate 702 described in relation to FIG. 7, semiconductor substrate 802 (e.g., wafer) may be any semiconductor material serving as the base layer of a semiconductor component (e.g., optoelectronic semiconductor device 800). Semiconductor substrate 802 may comprise Silicon, Silicon Carbide (SiC), or other similar semiconductor material.

The semiconductor substrate 802 may be doped by a first dopant type to create a semiconductor having a particular conductivity type. For example, the semiconductor substrate 802 of the example optoelectronic semiconductor device 800 is an n-typed semiconductor substrate 802.

The semiconductor substrate 802 may comprise a doping concentration. For example, the semiconductor substrate 802 comprises a high doping concentration of an n-type dopant compared to the semiconductor drift layer 870.

Semiconductor drift layer 870 may be any semiconductor material configured to enable the flow of current from the graphene layer 812 to the cathode terminal 872 as a result of the drift of majority carriers. The semiconductor drift layer 870 enables the flow of current from the graphene layer 812 to the cathode terminal 872 when the barrier voltage of the optoelectronic semiconductor device 800 is exceeded. Further, the semiconductor drift layer 870 blocks or limits the flow of current in the reverse direction, e.g., from the cathode terminal 872 to the anode terminal.

For example, the semiconductor drift layer 870 is of the same dopant type as the semiconductor substrate 802, here, an n-type semiconductor. For example, the semiconductor drift layer 870 has a lower doping concentration than the semiconductor substrate 802.

Graphene layer 812 has high conductivity and transparency. Therefore, the graphene layer 812 may be adopted as a transparent conducting electrode enabling optical collection of photons 880 and charge collection from the optoelectronic semiconductor device 800. Many semiconductor devices, including photodiodes and solar cells, convert the received optical photons 880 into an electrical signal. Graphene layer 812 may be used as a transparent conducting electrode in any situation benefitting from a low resistance electrical contact that does not block light.

In addition, due to the transparency of the graphene layer 812, photons 880 may be emitted from the graphene layer 812. For example, a laser diode, vertical-cavity surface-emitting laser (VCSEL), or other optical source may utilize a graphene layer 812 as a transparent conducting electrode allowing the electronic device to collect current and to emit photons 880.

Cathode terminal 872 forms a back-end contact pad.

The cathode terminal 872 may be any conductive material through which current exits the optoelectronic semiconductor device 800, or equivalently, electrons enter the optoelectronic semiconductor device 800. In particular, the cathode terminal 872 may comprise a metal, or combination of metals, such as molybdenum, platinum, chromium, tungsten, nickel, or other similar conductive material.

Here, the cathode terminal 872 is disposed below the semiconductor substrate 802, adjacent to the bottom surface of the semiconductor substrate 802.

The anode terminal 874 (e.g., front-end contact pad) may be any conductive surface configured to provide an electrical connection to the graphene layer 812 of the optoelectronic semiconductor device 800. Anode terminal 874 may comprise any conductive material, including gold, copper, aluminum, or other similar material.

Anode terminal 874 provides a point of contact to an external load to which current may be provided upon receipt of photons 880 and transmission of the photons into electrical energy.

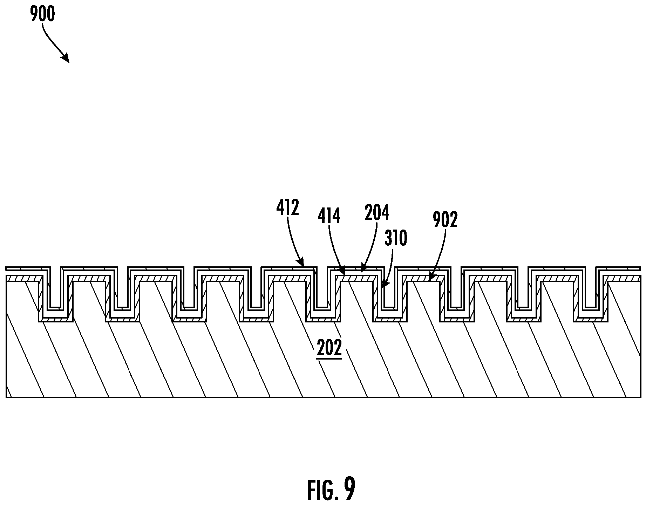

FIG. 9 shows an example semiconductor device 900 with an uneven top surface 902. In FIG. 9, same elements as in FIG.s 2 and 4 have been numbered using the same reference numbers.

In FIG. 9, example semiconductor device 900 includes graphene layer 412 formed on the exposed surfaces 310 of the metal catalyst layer 204. Metal silicide layer 414 has formed between the uneven top surface 902 of the semiconductor substrate 202 and the metal catalyst layer 204.

Graphene layer production utilizing mechanical transfer techniques are ineffective on an uneven top surface, such as the uneven top surface 902 depicted in FIG. 9. However, utilizing the techniques described herein, the graphene layer 412 is deposited on the uneven top surface 902 by a CVD process as described in relation to FIG. 5. Utilizing the techniques described herein, the graphene layer 412, is not only isolated to portions on the exposed surface 310 of the metal silicide layer 414, but the graphene layer 412 is also able to form on the various channels and voids on the uneven top surface 902 of the semiconductor substrate 202.

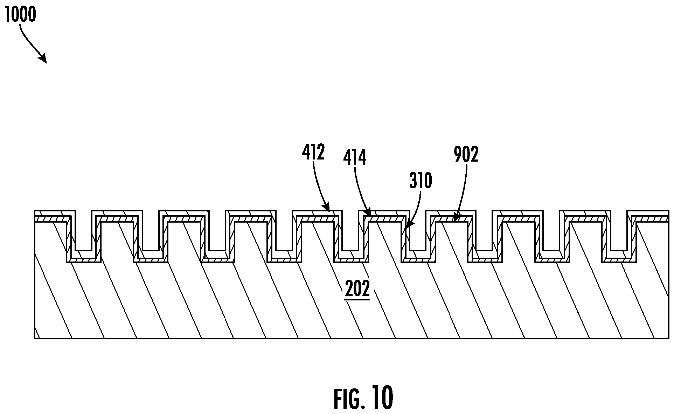

Referring now to FIG. 10, an example semiconductor device 1000 with an uneven top surface 902 is provided. As depicted in FIG. 10, the depicted semiconductor device 1000 includes metal silicide layer 414 disposed on the uneven top surface 902 of the semiconductor substrate 202. In addition, graphene layer is disposed on all the exposed surfaces 310 of the metal silicide layer 414.

Also here, metal silicide layer 414 is formed during the graphene growth process and in direct contact with both the graphene layer 412 and the uneven top surface 902 of the semiconductor substrate 202.

Also here,the entire metal catalyst layer (e.g., previously deposited metal catalyst layer 204 of FIG. 9) has been completely converted into metal silicide layer 414, as shown in FIG. 10. For example, the entire metal catalyst layer has been converted into Molybdenum Silicide (MoₓSi_{y}) or into Nickel Silicide (NiₓSi_{y}) during the graphene growth process.

Converting the entire metal catalyst layer into metal silicide layer 414 establishes a silicide contact between the graphene layer 412 and the semiconductor substrate 202.

Finally, it is clear that modifications and variations may be made to the method and the device described and illustrated herein without thereby departing from the scope of the present invention, as defined in the attached claims. For example, one skilled in the art may recognize that such principles may be applied to any electronic device or optoelectronic device that utilizes semiconductor devices required to withstand high temperatures, high power, and or high frequencies. For example, diodes and Schottky diodes in high power electronic devices; solar panels, photodiodes, and other devices configured to convert optical photons into electrical energy; and so on.

Various embodiments are directed to a method for forming a graphene layer on a semiconductor substrate, a semiconductor diode utilizing the method for graphene layer formation, and an optoelectronic semiconductor device utilizing the method for graphene layer formation, as summarized below:
A method for disposing a graphene layer on a semiconductor substrate comprising:
   depositing a metal catalyst layer on a top surface of the semiconductor substrate;
   patterning the metal catalyst layer, such that one or more portions of the top surface of the semiconductor substrate are covered by one or more metal catalyst layer structures; and
   facilitating a graphene growth process on an exposed surface of the one or more metal catalyst layer structures,
   wherein the graphene growth process forms the graphene layer on the exposed surfaces of the one or more metal catalyst layer structures.

The semiconductor substrate may comprise Silicon Carbide

The metal catalyst layer may form a metal silicide with the one or more portions of the semiconductor substrate covered by the one or more metal catalyst layer structures.

The semiconductor substrate may comprise one or more contact points,
wherein one or more of the one or more metal catalyst layer structures are patterned in alignment with the one or more contact points.

The one or more contact points may comprise an n-type or p-type semiconductor region with a low doping concentration, and the metal catalyst layer forms a Schottky contact between the graphene layer and the semiconductor substrate.

The one or more contact points may comprise an n-type or p-type semiconductor region with a high doping concentration, and the metal catalyst layer forms an ohmic contact between the graphene layer and the semiconductor substrate.

The one or more metal catalyst layer structures may be patterned such that during the graphene growth process the entire one or more metal catalyst layer structures underlying the graphene layer is transitioned to the metal silicide.

The metal catalyst layer may comprise a thickness between 45 nanometers and 55 nanometers.

The metal catalyst layer may comprise molybdenum.

The metal catalyst layer may comprise nickel.

The metal catalyst layer may be deposited by sputtering.

The one or more metal catalyst layer structures may be patterned using a metal etching photolithography process.

The graphene growth process may be facilitated using a chemical vapor deposition process, wherein the chemical vapor deposition process utilizes a carbon precursor.

Methane gas may be used as the carbon precursor in the chemical vapor deposition process.

During the chemical vapor deposition process, the metal catalyst layer may be exposed to the carbon precursor for a duration between 600 seconds and 700 seconds.

A semiconductor diode comprising:
a cathode terminal comprising a backside ohmic contact adjacent to a first doped silicon substrate,
wherein the first doped silicon substrate comprises a first doping concentration of a first doping type;
a drift layer comprising a second doped silicon substrate,
wherein the second doped silicon substrate comprises a second doping concentration of a second doping type;
a Schottky contact adjacent to a top surface of the drift layer, opposite the first doped silicon substrate,
wherein the Schottky contact is formed by:
   depositing a metal catalyst layer on the top surface of the drift layer;
   patterning the metal catalyst layer, such that one or more portions of the top surface of the drift layer are covered by one or more metal catalyst layer structures; and facilitating a graphene growth process on an exposed surface of the one or more metal catalyst layer structures,
   wherein the graphene growth process forms a graphene layer on the exposed surfaces of the one or more metal catalyst layer structures, and wherein the one or more metal catalyst layer structures are patterned such that during the graphene growth process, the entire one or more metal catalyst layer structure underlying the graphene layer is transitioned to a metal silicide; and
an anode terminal disposed on a top surface of the graphene layer,
   wherein the Schottky contact is formed between the graphene layer and the drift layer by the metal silicide,
   wherein the first doping type is the same as the second doping type, and wherein the first doping concentration is greater than the second doping concentration.

The first doped silicon substrate and the second doped silicon substrate may comprise Silicon Carbide.

The metal catalyst layer may comprise molybdenum.

An optoelectronic semiconductor device comprises:
a graphene layer configured to collect photo generated current from one or more photons, wherein the graphene layer is formed by:
   depositing a metal catalyst layer on a top surface of a semiconductor substrate;
   patterning the metal catalyst layer, such that one or more portions of the top surface of the semiconductor substrate are covered by one or more metal catalyst layer structures; and
   facilitating a graphene growth process on an exposed surface of the one or more metal catalyst layer structures,
      wherein the graphene growth process forms the graphene layer on the exposed surfaces of the one or more metal catalyst layer structures, and wherein the one or more metal catalyst layer structures are patterned such that during the graphene growth process, the entire one or more metal catalyst layer structure underlying the graphene layer is transitioned to a metal silicide;
an anode terminal in electrical contact with the graphene layer;
a semiconductor diode junction in electrical contact with the metal silicide on a top surface of the semiconductor diode junction; and
a cathode terminal in electrical contact with the semiconductor diode junction, on a bottom surface, opposite the metal silicide;
wherein in an instance in which the graphene layer collects the photo generated current from the one or more photons, an electrical current flows from the anode terminal, to the cathode terminal, through the semiconductor diode junction.

The semiconductor diode junction may comprise:
a first doped silicon substrate,
   wherein the first doped silicon substrate comprises a first doping concentration of a first doping type; and
a drift layer comprising a second doped silicon substrate,
   wherein the second doped silicon substrate comprises a second doping concentration of a second doping type;
   wherein the first doping type is the same as the second doping type,
wherein the first doping concentration is greater than the second doping concentration, and
wherein the first doped silicon substrate and the drift layer comprise Silicon Carbide.

## Claims

1. A method for disposing a graphene layer on a semiconductor substrate, the method comprising:
depositing, for example by sputtering, a metal catalyst layer (204) on a top surface (206) of the semiconductor substrate (202);
patterning the metal catalyst layer, such that one or more portions of the top surface of the semiconductor substrate are covered by one or more metal catalyst layer structures (308); and
facilitating a graphene growth process on an exposed surface of the one or more metal catalyst layer structures,
wherein the graphene growth process forms the graphene layer (412) on the exposed surfaces of the one or more metal catalyst layer structures.

2. The method of claim 1, wherein the semiconductor substrate (202) comprises Silicon Carbide.

3. The method of claim 1 or 2, wherein the metal catalyst layer (204) forms a metal silicide (414) with the one or more portions of the semiconductor substrate (202) covered by the one or more metal catalyst layer structures (308).

4. The method of any of the preceding claims, wherein the semiconductor substrate (202) comprises one or more contact points, and
wherein one or more of the one or more metal catalyst layer structures (308) are patterned in alignment with the one or more contact points.

5. The method of the preceding claim, wherein the one or more contact points comprise an n-type or p-type semiconductor region, and
wherein the metal catalyst layer (204) forms a Schottky or an ohmic contact between the graphene layer and the semiconductor substrate.

6. The method of claim 3 or any of claims 4 and 5, when depending on claim 3, wherein the entire one or more metal catalyst layer structure (308) underlying the graphene layer (412) is transitioned to the metal silicide.

7. The method of the preceding claim, wherein the metal catalyst layer (204) comprises a thickness between 45 nanometers and 55 nanometers.

8. The method of any of the preceding claims, wherein the metal catalyst layer comprises molybdenum or nickel.

9. The method of claim 1, wherein the graphene growth process is facilitated using a chemical vapor deposition process, and
wherein the chemical vapor deposition process utilizes a carbon precursor such as . methane gas.

10. The method of the preceding claim, wherein during the chemical vapor deposition process, the metal catalyst layer (204) is exposed to the carbon precursor for a duration between 600 seconds and 700 seconds.

11. A semiconductor device comprising:
a first terminal (772; 872) comprising a backside contact adjacent to a semiconductor body (202),
a metal silicide contact adjacent to a top surface (206; 902) of the semiconductor body (202), opposite the backside contact,
wherein the metal silicide contact is formed by:
depositing a metal catalyst layer (204) on the top surface (206) of the semiconductor body (202);
patterning the metal catalyst layer, such that one or more portions of the top surface of the drift layer are covered by one or more metal catalyst layer structures (308); and
facilitating a graphene growth process on an exposed surface of the one or more metal catalyst layer structures,
wherein the graphene growth process forms a graphene layer (412; 712; 812) on the exposed surfaces of the one or more metal catalyst layer structures; and
an anode terminal (774; 874) disposed on a top surface of the graphene layer.

12. The semiconductor device according to the preceding claim, forming a semiconductor diode (700), wherein:
the first terminal (772) is a cathode terminal and the backside contact is an ohmic contact;
the semiconductor body (202) includes:
a first doped silicon substrate (702) comprising a first doping concentration of a first doping type;
a drift layer (770) comprising a second doped silicon substrate, the second doped silicon substrate comprising a second doping concentration of a second doping type;
wherein the cathode terminal (772) is adjacent to the first doped silicon substrate,
the metal silicide contact is a Schottky contact (714),
the Schottky contact (714) is adjacent the drift layer, opposite the first doped silicon substrate (702),
wherein, during facilitating the graphene growth process, the one or more metal catalyst layer structures (308) are patterned such that, during the graphene growth process, the entire one or more metal catalyst layer structures underlying the graphene layer (712) are transitioned to metal silicide; and
wherein the Schottky contact (714) is formed between the graphene layer (712) and the drift layer (770) by the metal silicide,
wherein the first doping type is the same as the second doping type, and
wherein the first doping concentration is greater than the second doping concentration.

13. The semiconductor device of the preceding claim, wherein the first doped silicon substrate (702) and the second doped silicon substrate (770) comprise Silicon Carbide.

14. The semiconductor device according to claim 12, forming an optoelectronic semiconductor device, wherein:
the graphene layer (812) configured to collect photo generated current from one or more photons,
wherein, during facilitating a graphene growth process, the one or more metal catalyst layer structures (308) are patterned such that during the graphene growth process, the entire one or more metal catalyst layer structures (308) underlying the graphene layer are transitioned to metal silicide;
the optoelectronic semiconductor device further comprising:
a semiconductor diode junction formed by electrical contact of the metal silicide
contact (814) on a top surface of the semiconductor body (802, 870); and
a cathode terminal (872) in electrical contact with the semiconductor diode junction, on a bottom surface, opposite the metal silicide contact.

15. The semiconductor device of the preceding claim, wherein the semiconductor body comprises:
a first doped silicon substrate (802), wherein the first doped silicon substrate comprises a first doping concentration of a first doping type; and
a drift layer (870) comprising a second doped silicon substrate, wherein the second doped silicon substrate comprises a second doping concentration of a second doping type;
wherein the first doping type is the same as the second doping type,
wherein the first doping concentration is greater than the second doping concentration, and
wherein the first doped silicon substrate and the drift layer comprise Silicon Carbide.
